# EUROPEAN PATENT APPLICATION

(11) **EP 4 447 639 A1**
(43) Date of publication of application: **16.10.2024**
(21) Application number: 24164445.9
(22) Date of filing: 19.03.2024
(51) Int. Cl.: H10K 59/124, H10K 59/131, H10K 50/813

(54) **ELECTRONIC DEVICE**

(30) Priority: 11.04.2023 KR 20230047679; 21.06.2023 KR 20230079772
(71) Applicant: Samsung Display Co., Ltd., Yongin-si, Gyeonggi-do 17113 (KR)
(72) Inventor: SHIM, Yongsub, Giheung-gu, Yongin-si, Gyeonggi-do (KR); KIM, Youngjae, Giheung-gu, Yongin-si, Gyeonggi-do (KR); KIM, Jin-Yup, Giheung-gu, Yongin-si, Gyeonggi-do (KR); PARK, Jong-Heon, Giheung-gu, Yongin-si, Gyeonggi-do (KR); YOO, Younghyun, Giheung-gu, Yongin-si, Gyeonggi-do (KR); YOO, Jewon, Giheung-gu, Yongin-si, Gyeonggi-do (KR); LEE, Yoonyeol, Giheung-gu, Yongin-si, Gyeonggi-do (KR); CHO, Hyung Keon, Giheung-gu, Yongin-si, Gyeonggi-do (KR); HONG, Sung-Hwan, Giheung-gu, Yongin-si, Gyeonggi-do (KR); HONG, Jongbeom, Giheung-gu, Yongin-si, Gyeonggi-do (KR)
(74) Representative: Dr. Weitzel & Partner

(57) **Abstract**

An electronic device including: a base layer (110); a circuit layer (120) on the base layer, the circuit layer including pixel drive circuits (PDC) and an insulating layer (70, 70ip) covering the pixel drive circuits; and a light emitting element layer (130) on the circuit layer, the light emitting element layer including light emitting elements respectively electrically connected to the pixel drive circuits. The light emitting elements include first through third light emitting elements respectively including first through third pixel electrodes. The insulating layer has first through third upper surface portion respectively overlapping the first through third pixel electrodes, and degrees of flatness of the first, second, and third upper surface portions differ from one another.

## Description

### BACKGROUND

### 1. Field

Aspects of embodiments of the present invention relate to an electronic device having improved display quality.

### 2. Description of the Related Art

Multimedia electronic devices, such as a television, a mobile phone, a tablet computer, a car navigation unit, a game machine, and the like, include an electronic device for displaying an image. The electronic device may include an organic light emitting electronic device. The organic light emitting electronic device may include light emitting elements, and the light emitting elements may generate light by the recombination of electrons and holes. The organic light emitting electronic device has a fast response speed and is driven with low power consumption.

### SUMMARY

Embodiments of the present invention provide an electronic device having improved display quality by improving viewing angle characteristics.

The present invention is defined by the independent claims.

According to the present invention, an electronic device includes a base layer, a circuit layer on the base layer and including a plurality of pixel drive circuits and an insulating layer covering the plurality of pixel drive circuits, and a light emitting element layer on the circuit layer and including a plurality of light emitting elements respectively electrically connected to the plurality of pixel drive circuits. The plurality of light emitting elements include a first light emitting element including a first pixel electrode, a second light emitting element including a second pixel electrode, and a third light emitting element including a third pixel electrode. The insulating layer has a first upper surface portion overlapping the first pixel electrode, a second upper surface portion overlapping the second pixel electrode, and a third upper surface portion overlapping the third pixel electrode. Degrees of flatness of the first upper surface portion, the second upper surface portion, and the third upper surface portion differ from one another.

The circuit layer may further include a drive voltage line that provides a drive voltage to the plurality of pixel drive circuits, and the drive voltage line may overlap at least portions of the first pixel electrode, the second pixel electrode, and the third pixel electrode.

The first pixel electrode may have a first central region and a first outer region adjacent to the first central region. The second pixel electrode may have a second central region and a second outer region adjacent to the second central region. The third pixel electrode may have a third central region and a third outer region adjacent to the third central region. The drive voltage line may overlap at least one of the first central region and the second central region.

The drive voltage line may not overlap the third central region and may overlap the third outer region.

A height of a portion of the first upper surface portion that overlaps the first central region may be greater than a height of a portion of the first upper surface portion that overlaps the first outer region.

A height of a portion of the third upper surface portion that overlaps the third central region may be smaller than a height of a portion of the third upper surface portion that overlaps the third outer region.

The degree of flatness of the second upper surface portion may be higher than the degree of flatness of the first upper surface portion and the degree of flatness of the third upper surface portion.

The first light emitting element may be a red light emitting element, the second light emitting element may be a green light emitting element, and the third light emitting element may be a blue light emitting element.

The first light emitting element and the second light emitting element may be alternately and repeatedly arranged in a first direction, and the third light emitting element may be adjacent to the first light emitting element and the second light emitting element in a second direction crossing the first direction.

The circuit layer may further include a drive voltage line that provides a drive voltage to the plurality of pixel drive circuits. The drive voltage line may include: a first voltage line that extends in a first direction and overlaps the first pixel electrode and the second pixel electrode; and a second voltage line and a third voltage line that overlap the third pixel electrode.

The first voltage line, the second voltage line, and the third voltage line may be spaced apart from each other in a second direction crossing the first direction, and a maximum width of a portion of the first voltage line that overlaps the first pixel electrode and the second pixel electrode in the second direction may be greater than a maximum width of a portion of the second voltage line that overlaps the third pixel electrode in the second direction and a maximum width of a portion of the third voltage line that overlaps the third pixel electrode in the second direction.

The insulating layer may be an organic layer, and the first pixel electrode, the second pixel electrode, and the third pixel electrode may be directly on an upper surface of the insulating layer.

According to another aspect of the present invention, an electronic device includes a base layer, a circuit layer on the base layer and including a plurality of pixel drive circuits, a first voltage line that provides a drive voltage to the plurality of pixel drive circuits, and an insulating layer covering the plurality of pixel drive circuits and the first voltage line, and a light emitting element layer on the circuit layer and including a plurality of light emitting elements respectively electrically connected to the plurality of pixel drive circuits. The plurality of light emitting elements include a first light emitting element including a first pixel electrode, a second light emitting element including a second pixel electrode that overlaps the first voltage line, and a third light emitting element including a third pixel electrode. Degrees of flatness of the first pixel electrode, the second pixel electrode, and the third pixel electrode differ from one another.

The first pixel electrode may have a first central region and a first outer region adjacent to the first central region. The second pixel electrode may have a second central region and a second outer region adjacent to the second central region. The third pixel electrode may have a third central region and a third outer region adjacent to the third central region. The first voltage line may overlap the first central region and the second central region.

The insulating layer may have a first upper surface portion that overlaps the first pixel electrode, a second upper surface portion that overlaps the second pixel electrode, and a third upper surface portion that overlaps the third pixel electrode, and the degree of flatness of the second upper surface portion may be higher than the degree of flatness of the first upper surface portion and the degree of flatness of the third upper surface portion.

A height of a portion of the first upper surface portion that overlaps the first central region may be greater than a height of a portion of the first upper surface portion that overlaps the first outer region.

A height of a portion of the third upper surface portion that overlaps the third central region may be smaller than a height of a portion of the third upper surface portion that overlaps the third outer region.

The circuit layer may further include a second voltage line and a third voltage line that provide the drive voltage and overlap the third pixel electrode. Each of the first voltage line, the second voltage line, and the third voltage line may extend in a first direction. The first voltage line, the second voltage line, and the third voltage line may be spaced apart from each other in a second direction crossing the first direction.

A maximum width of a portion of the first voltage line that overlaps the first pixel electrode and the second pixel electrode in the second direction may be greater than a maximum width of a portion of the second voltage line that overlaps the third pixel electrode in the second direction and a maximum width of a portion of the third voltage line that overlaps the third pixel electrode in the second direction.

The insulating layer may be an organic layer, and the first pixel electrode, the second pixel electrode, and the third pixel electrode may be directly on an upper surface of the insulating layer.

### BRIEF DESCRIPTION OF THE DRAWINGS

The above and other aspects and features of the present invention will become apparent by describing, in detail, embodiments thereof with reference to the accompanying drawings.
FIG. 1 is a perspective view of an electronic device according to an embodiment of the present invention.
FIG. 2A is a cross-sectional view of the electronic device according to an embodiment of the present invention.
FIG. 2B is a cross-sectional view of an electronic device according to an embodiment of the present invention.
FIG. 3 is a plan view illustrating a portion of a display layer according to an embodiment of the present invention.
FIG. 4 is an equivalent circuit diagram of a pixel according to an embodiment of the present invention.
FIG. 5 is a plan view illustrating a portion of the display layer according to an embodiment of the present invention.
FIG. 6A is a cross-sectional view of a preliminary display layer according to an embodiment of the present invention.
FIG. 6B is a cross-sectional view of the preliminary display layer according to an embodiment of the present invention.
FIG. 6C is a cross-sectional view of the preliminary display layer according to an embodiment of the present invention.
FIG. 7A is a plan view of a mask used in a manufacturing process of the display layer according to an embodiment of the present invention.
FIG. 7B is a plan view of the mask used in the manufacturing process of the display layer according to an embodiment of the present invention.
FIG. 8A is a cross-sectional view of the display layer according to an embodiment of the present invention.
FIG. 8B is a cross-sectional view of the display layer according to an embodiment of the present invention.
FIG. 8C is a cross-sectional view of the display layer according to an embodiment of the present invention.
FIG. 9 is a plan view of a mask used in a manufacturing process of a display layer according to an embodiment of the present invention.
FIG. 10 is a cross-sectional view of the display layer according to an embodiment of the present invention.

### DETAILED DESCRIPTION

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present invention relates to "one or more embodiments of the present invention." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present invention and is not intended to be limiting of the present invention. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

The terms "part" and "unit" may refer to a software component or a hardware component that performs a specific function. The hardware component may include, for example, a field-programmable gate array (FPGA) or an application-specific integrated circuit (ASIC). The software component may refer to executable code and/or data used by executable code in an addressable storage medium. Thus, software components may be, for example, object-oriented software components, class components, and working components and may include processes, functions, properties, procedures, subroutines, program code segments, drivers, firmware, micro-codes, circuits, data, databases, data structures, tables, arrays or variables.

Unless otherwise defined, all terms used herein, including technical or scientific terms, have the same meanings as those generally understood by those skilled in the art to which the present invention pertains. Such terms as those defined in a generally used dictionary are to be interpreted as having meanings equal to the contextual meanings in the relevant field of art and are not to be interpreted as having ideal or excessively formal meanings unless clearly defined as having such in the present application.

Hereinafter, embodiments of the present invention will be described with reference to the accompanying drawings.

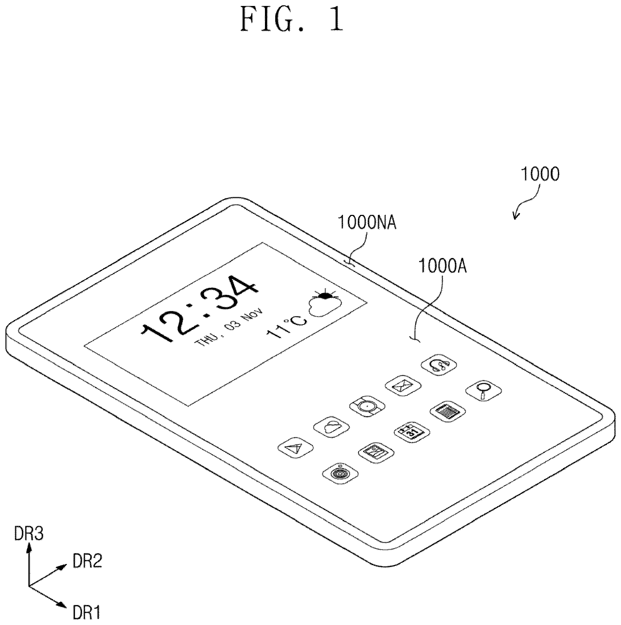

FIG. 1 is a perspective view of an electronic device 1000 according to an embodiment of the present invention.

Referring to FIG. 1, the electronic device 1000 may be activated according to an electrical signal. For example, the electronic device 1000 may be a mobile phone, a foldable mobile phone, a notebook computer, a television, a tablet computer, a car navigation unit, a game machine, or a wearable device but is not limited thereto. In FIG. 1, the electronic device 1000 is illustrated as being a tablet computer, but this is merely an example.

The electronic device 1000 may have an active region 1000A and a peripheral region 1000NA defined therein. The electronic device 1000 may display an image through (or at) the active region 1000A. The active region 1000A may be on a plane defined by a first direction DR1 and a second direction DR2. The peripheral region 1000NA may surround (e.g., may extend around) the periphery of the active region 1000A. In an embodiment of the present invention, the peripheral region 1000NA may be omitted.

The thickness direction of the electronic device 1000 may be parallel to a third direction DR3 that crosses the first direction DR1 and the second direction DR2. Accordingly, front surfaces (or upper surfaces) and rear surfaces (or lower surfaces) of members constituting the electronic device 1000 may be defined based on the third direction DR3.

Although the electronic device 1000 is illustrated as being a bar (or rectangular) type device in FIG. 1, the present invention is not limited thereto. For example, the following description may be applied to various electronic devices, such as a foldable electronic device, a rollable electronic device, or a slidable electronic device.

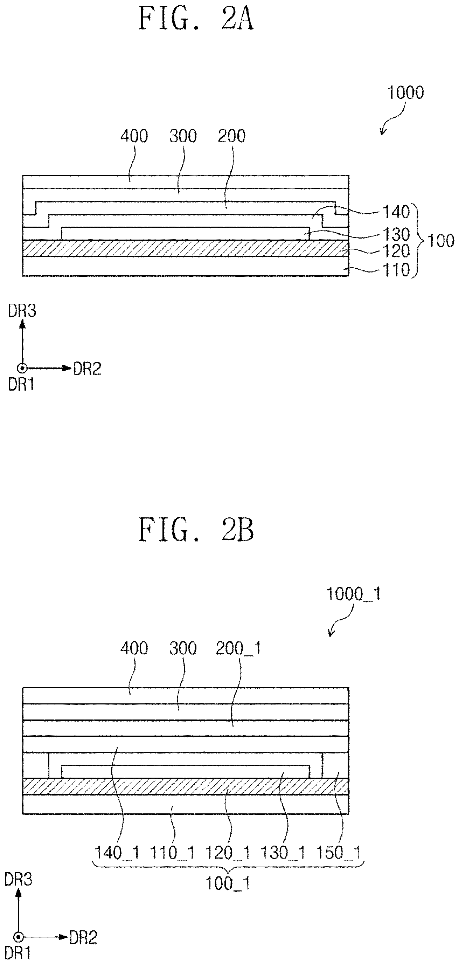

FIG. 2A is a cross-sectional view of the electronic device 1000 according to an embodiment of the present invention.

Referring to FIG. 2A, the electronic device 1000 may include a display layer 100, a sensor layer 200, an anti-reflective layer 300, and a window 400.

The display layer 100 may include a base layer 110, a circuit layer 120, a light emitting element layer 130, and an encapsulation layer 140.

The base layer 110 may be a member that provides a base surface on which the circuit layer 120 is disposed. The base layer 110 may be a glass substrate, a metal substrate, a polymer substrate, or the like. However, without being limited thereto, the base layer 110 may be an inorganic layer, an organic layer, or a composite layer.

The circuit layer 120 may be disposed on the base layer 110. The circuit layer 120 may include an insulating layer, a semiconductor pattern, a conductive pattern, and a signal line. The insulating layer, the semiconductor layer, and the conductive layer may be formed on the base layer 110 by a suitable process, such as coating or deposition, and may be selectively patterned by a photolithography process a plurality of times. Thereafter, the semiconductor pattern, the conductive pattern, and the signal line included in the circuit layer 120 may be formed.

The light emitting element layer 130 may be disposed on the circuit layer 120. The light emitting element layer 130 may include light emitting elements. For example, the light emitting element layer 130 may include an organic light emitting material, an inorganic light emitting material, an organic-inorganic light emitting material, a quantum dot, a quantum rod, a micro LED, or a nano LED.

The encapsulation layer 140 may be disposed on the light emitting element layer 130. The encapsulation layer 140 may protect the light emitting element layer 130 from moisture, oxygen, and foreign matter, such as dust particles.

The sensor layer 200 may be disposed on the display layer 100. The sensor layer 200 may be formed on the display layer 100 through a continuous process. In such an embodiment, the sensor layer 200 may be expressed as being directly disposed on the display layer 100. When the sensor layer 200 is directly disposed on the display layer 100, this may mean that a third component is not disposed between the sensor layer 200 and the display layer 100. For example, a separate adhesive member may not be disposed between the sensor layer 200 and the display layer 100. In another embodiment, the sensor layer 200 may be coupled with the display layer 100 through an adhesive member. The adhesive member may include a conventional adhesive or sticky substance.

The anti-reflective layer 300 may be disposed on the sensor layer 200. The anti-reflective layer 300 may decrease the reflectance of external light incident from outside the electronic device 1000. The anti-reflective layer 300 may be directly disposed on the sensor layer 200. However, without being limited thereto, an adhesive member may be disposed between the anti-reflective layer 300 and the sensor layer 200.

The window 400 may be disposed on the anti-reflective layer 300. The window 400 may include an optically transparent insulating material. For example, the window 400 may include glass or plastic. The window 400 may have a multi-layer structure or a single-layer structure. For example, the window 400 may include a plurality of plastic films coupled through an adhesive or may include a glass substrate and a plastic film coupled through an adhesive.

FIG. 2B is a cross-sectional view of an electronic device 1000_1 according to an embodiment of the present invention.

Referring to FIG. 2B, the electronic device 1000_1 may include a display layer 100_1, a sensor layer 200_1, an anti-reflective layer 300, and a window 400.

The display layer 100_1 may include a base substrate 110_1, a circuit layer 120_1, a light emitting element layer 130_1, an encapsulation substrate 140_1, and a coupling member 150_1.

Each of the base substrate 110_1 and the encapsulation substrate 140_1 may be a glass substrate, a metal substrate, or a polymer substrate but is not limited thereto.

The coupling member 150_1 may be disposed between the base substrate 110_1 and the encapsulation substrate 140_1. The coupling member 150_1 may couple the encapsulation substrate 140_1 to the base substrate 110_1 or the circuit layer 120_1. The coupling member 150_1 may include an inorganic material or an organic material. For example, the inorganic material may include a frit seal, and the organic material may include a photo-curable resin or a photo-plastic resin. However, the material of the coupling member 150_1 is not limited to these examples.

The sensor layer 200_1 may be directly disposed on the encapsulation substrate 140_1. When the sensor layer 200_1 is directly disposed on the encapsulation substrate 140_1, this may mean that a third component is not disposed between the sensor layer 200_1 and the encapsulation substrate 140_1. For example, a separate adhesive member may not be disposed between the sensor layer 200_1 and the display layer 100_1. However, without being limited thereto, an adhesive layer may be additionally disposed between the sensor layer 200_1 and the encapsulation substrate 140_1.

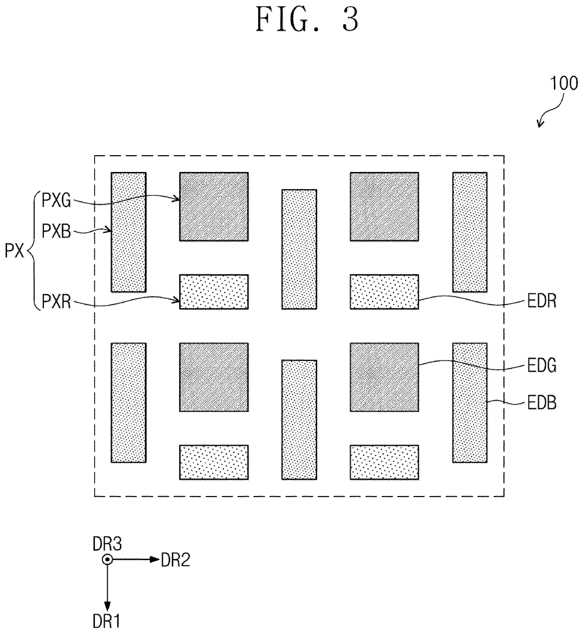

FIG. 3 is a plan view illustrating a portion of the display layer 100 according to an embodiment of the present invention.

Referring to FIGS. 2A and 3, the display layer 100 may include a plurality of pixels PX disposed to overlap the active region 1000A (see, e.g., FIG. 1). The plurality of pixels PX may include first pixels PXR, second pixels PXG, and third pixels PXB. The first pixels PXR may be red pixels, the second pixels PXG may be green pixels, and the third pixels PXB may be blue pixels. However, the present invention is not limited thereto.

The first pixels PXR may include first light emitting elements EDR, the second pixels PXG may include second light emitting elements EDG, and the third pixels PXB may include third light emitting elements EDB. Accordingly, the first light emitting elements EDR may be red light emitting elements, the second light emitting elements EDG may be green light emitting elements, and the third light emitting elements EDB may be blue light emitting elements. However, the present invention is not limited thereto.

The first light emitting elements EDR may alternate with (or may be alternately arranged with) the second light emitting elements EDG in the first direction DR1. The third light emitting elements EDB may be disposed adjacent to the first light emitting elements EDR and the second light emitting elements EDG in the second direction DR2 crossing the first direction DR1. The arrangement pattern of the plurality of pixels PX illustrated in FIG. 3 is merely illustrative, and the present invention is not limited thereto.

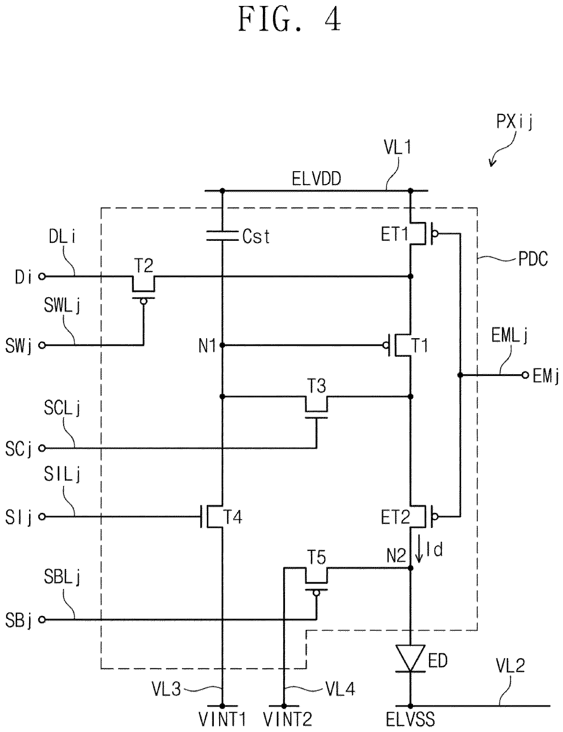

FIG. 4 is an equivalent circuit diagram of a pixel PXij according to an embodiment of the present invention.

Referring to FIG. 4, an equivalent circuit diagram of one pixel PXij from among the plurality of pixels PXR, PXG, and PXB (see, e.g., FIG. 3) is illustrated as an example. The plurality of pixels PXR, PXG, and PXB have substantially the same circuit structure. Therefore, the circuit structure for the pixel PXij will be described, and detailed description of the remaining pixels PXR, PXG, and PXB will be omitted.

The pixel PXij may be connected to the i-th data line DLi, the j-th initialization scan line SILj, the j-th compensation scan line SCLj, the j-th write scan line SWLj, the j-th black scan line SBLj, and the j-th emission control line EMLj.

The pixel PXij includes a light emitting element ED and a pixel drive circuit PDC. The light emitting element ED may be a light emitting diode. In an embodiment of the present invention, the light emitting element ED may be an organic light emitting diode including an organic light emitting layer but is not limited thereto. The pixel drive circuit PDC may be included in the circuit layer 120 (see, e.g., FIG. 2A), and the light emitting element ED may be included in the light emitting element layer 130 (see, e.g., FIG. 2A).

The pixel drive circuit PDC includes first to fifth transistors T1, T2, T3, T4, and T5, first and second emission control transistors ET1 and ET2, and a capacitor Cst.

At least one of the first to fifth transistors T1, T2, T3, T4, and T5 and the first and second emission control transistors ET1 and ET2 may be a transistor having a low-temperature polycrystalline silicon (LTPS) semiconductor layer. At least one of the first to fifth transistors T1, T2, T3, T4, and T5 and the first and second emission control transistors ET1 and ET2 may be a transistor having an oxide semiconductor layer. For example, the third and fourth transistors T3 and T4 may be oxide semiconductor transistors, and the first, second, and fifth transistors T1, T2, and T5 and the first and second emission control transistors ET1 and ET2 may be LTPS transistors.

For example, the first transistor T1 directly affecting (or controlling) the brightness of the electronic device 1000 (or of the light emitting element ED) may include a semiconductor layer formed of polycrystalline silicon having high reliability, and thus, the electronic device 1000 having a high resolution may be implemented. An oxide semiconductor has high carrier mobility and low leakage current, and therefore, it does not exhibit significant a voltage drop even extending operating time. That is, the color of an image is not substantially changed depending on a voltage drop even during a low-frequency operation, and therefore, low-frequency operation is possible. Because the oxide semiconductor exhibits low leakage current, as described above, at least one of the third transistor T3, which is connected with a third electrode (or a gate electrode) of the first transistor T1, and the fourth transistor T4 may include an oxide semiconductor to reduce power consumption while preventing leakage current that is likely to flow to the gate electrode.

Some of the first to fifth transistors T1, T2, T3, T4, and T5 and the first and second emission control transistors ET1 and ET2 may be P-type transistors, and the others may be N-type transistors. For example, the first, second, and fifth transistors T1, T2, and T5 and the first and second emission control transistors ET1 and ET2 may be P-type transistors, and the third and fourth transistors T3 and T4 may be N-type transistors.

The configuration of the pixel drive circuit PDC according to the present invention is not limited to the embodiment illustrated in FIG. 4. The pixel drive circuit PDC illustrated in FIG. 4 is merely illustrative, and various changes and modifications may be made to the configuration of the pixel drive circuit PDC. For example, the first to fifth transistors T1, T2, T3, T4, and T5 and the first and second emission control transistors ET1 and ET2 may all be P-type transistors or N-type transistors.

The j-th initialization scan line SILj, the j-th compensation scan line SCLj, the j-th write scan line SWLj, the j-th black scan line SBLj, and the j-th emission control line EMLj may transfer the j-th initialization scan signal Slj, the j-th compensation scan signal SCj, the j-th write scan signal SWj, the j-th black scan signal SBj, and the j-th emission control signal EMj to the pixel PXij, respectively. The i-th data line DLi transfers the i-th data signal Di to the pixel PXij. The i-th data signal Di may have a voltage level corresponding to image data.

First and second drive voltage lines VL1 and VL2 may transfer a first drive voltage ELVDD and a second drive voltage ELVSS to the pixel PXij, respectively. Furthermore, first and second initialization voltage lines VL3 and VL4 may transfer a first initialization voltage VINT1 and a second initialization voltage VINT2 to the pixel PXij, respectively. In this specification, the first drive voltage ELVDD may be referred to as the drive voltage, and the first drive voltage line VL1 may be referred to as the drive voltage line.

The first transistor T1 is connected between the first drive voltage line VL1, which receives the first drive voltage ELVDD, and the light emitting element ED. The first transistor T1 includes a first electrode connected with the first drive voltage line VL1 via the first emission control transistor ET1, a second electrode connected with the light emitting element ED via the second emission control transistor ET2, and the third electrode (e.g., the gate electrode) connected with one end (or one electrode) of the capacitor Cst (e.g., a first node N1). The first transistor T1 may receive the i-th data signal Di from the i-th data line DLi depending on (or according to) a switching operation of the second transistor T2 and may supply drive current Id to the light emitting element ED.

The second transistor T2 is connected between the i-th data line DLi and the first electrode of the first transistor T1. The second transistor T2 includes a first electrode connected with the i-th data line DLi, a second electrode connected with the first electrode of the first transistor T1, and a third electrode (e.g., a gate electrode) connected with the j-th write scan line SWLj. The second transistor T2 may be turned on depending on (or according to) the j-th write scan signal SWj transferred through the j-th write scan line SWLj and may transfer, to the first electrode of the first transistor T1, the i-th data signal Di transferred from the i-th data line DLi.

The third transistor T3 is connected between the second electrode of the first transistor T1 and the first node N1. The third transistor T3 includes a first electrode connected with the third electrode of the first transistor T1, a second electrode connected with the second electrode of the first transistor T1, and a third electrode (e.g., a gate electrode) connected with the j-th compensation scan line SCLj. The third transistor T3 may be turned on depending on (or according to) the j-th compensation scan signal SCj transferred through the j-th compensation scan line SCLj and may diode-connect the first transistor T1 by connecting the third electrode and the second electrode of the first transistor T1.

The fourth transistor T4 is connected between the first initialization voltage line VL3, through which the first initialization voltage VINT1 is applied, and the first node N1. The fourth transistor T4 includes a first electrode connected with the first initialization voltage line VL3 through which the first initialization voltage VINT1 is transferred, a second electrode connected with the first node N1, and a third electrode (e.g., a gate electrode) connected with the j-th initialization scan line SILj. The fourth transistor T4 is turned on depending on (or according to) the j-th initialization scan signal Slj transferred through the j-th initialization scan line SILj. When turned-on, the fourth transistor T4 initializes the potential of the third electrode of the first transistor T1 (e.g., the potential of the first node N1) by transferring the first initialization voltage VINT1 to the first node N1.

The first emission control transistor ET1 includes a first electrode connected with the first drive voltage line VL1, a second electrode connected with the first electrode of the first transistor T1, and a third electrode (e.g., a gate electrode) connected to the j-th emission control line EMLj.

The second emission control transistor ET2 includes a first electrode connected with the second electrode of the first transistor T1, a second electrode connected to the light emitting element ED, and a third electrode (e.g., a gate electrode) connected to the j-th emission control line EMLj.

The first and second emission control transistors ET1 and ET2 are concurrently (or simultaneously) turned on depending on (or according to) the j-th emission control signal EMj transferred through the j-th emission control line EMLj. The first drive voltage ELVDD applied through the turned-on first emission control transistor ET1 may be compensated for through the diode-connected first transistor T1 and may be transferred to the light emitting element ED.

The fifth transistor T5 includes a first electrode connected to the second initialization voltage line VL4 through which the second initialization voltage VINT2 is transferred, a second electrode connected with a second node N2, and a third electrode (e.g., a gate electrode) connected with the j-th black scan line SBLj. The second initialization voltage VINT2 may have a voltage level lower than or equal to the voltage level of the first initialization voltage VINT1.

The one end (or the one electrode) of the capacitor Cst is connected with the third electrode of the first transistor T1, as described above, and an opposite end (or an opposite electrode) of the capacitor Cst is connected with the first drive voltage line VL1. A cathode of the light emitting element ED may be connected with the second drive voltage line VL2 that transfers the second drive voltage ELVSS. The second drive voltage ELVSS may have a lower voltage level than the first drive voltage ELVDD.

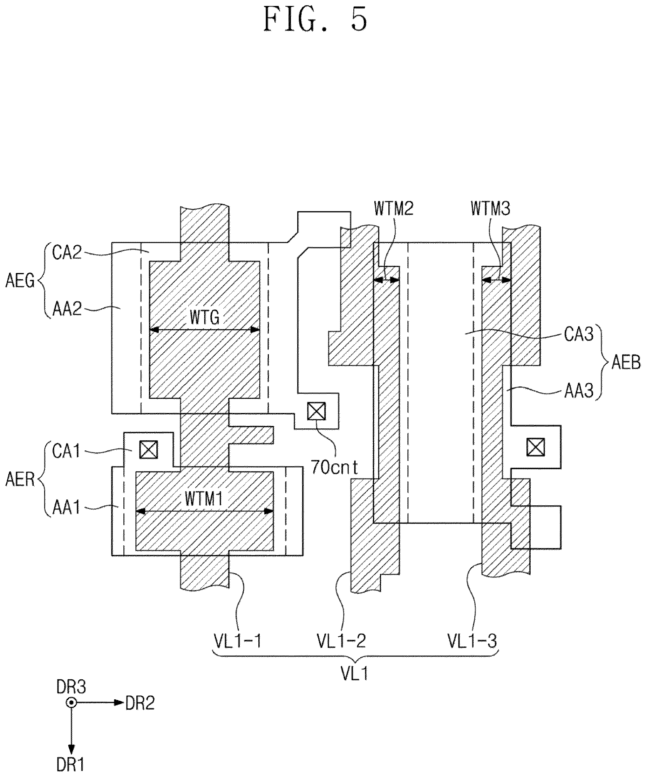

FIG. 5 is a plan view illustrating a portion of the display layer 100 (see, e.g., FIG. 3) according to an embodiment of the present invention.

Referring to FIGS. 3 and 5, a first pixel electrode AER included in the first light emitting element EDR, a second pixel electrode AEG included in the second light emitting element EDG, a third pixel electrode AEB included in the third light emitting element EDB, and the drive voltage line VL1 are illustrated in FIG. 5.

The first pixel electrode AER may have a first central region CA1 and a first outer region AA1 adjacent to the first central region CA1, the second pixel electrode AEG may have a second central region CA2 and a second outer region AA2 adjacent to the second central region CA2, and the third pixel electrode AEB may have a third central region CA3 and a third outer region AA3 adjacent to the third central region CA3. The first to third central regions CA1, CA2, and CA3 may be regions including the centers of the first to third pixel electrodes AER, AEG, and AEB, respectively.

In an embodiment of the present invention, the drive voltage line VL1 may overlap at least portions of the first pixel electrode AER, the second pixel electrode AEG, and the third pixel electrode AEB. In such an embodiment, as the area of the drive voltage line VL1 is increased, the resistance of the drive voltage line VL1 may be decreased, and thus, the power consumption of the electronic device 1000 (see, e.g., FIG. 1) may be reduced.

In an embodiment of the present invention, the drive voltage line VL1 may overlap the first central region CA1 and the second central region CA2. The drive voltage line VL1 may not overlap the third central region CA3 but may overlap the third outer region AA3.

The drive voltage line VL1 may include a first voltage line VL1-1, a second voltage line VL1-2, and a third voltage line VL1-3 that extend in the first direction DR1. The first to third voltage lines VL1-1, VL1-2, and VL1-3 may be spaced apart from each other in the second direction DR2. The first voltage line VL1-1 may overlap the first pixel electrode AER and the second pixel electrode AEG, and the second voltage line VL1-2 and the third voltage line VL1-3 may overlap the third pixel electrode AEB.

In an embodiment of the present invention, the maximum width WTM1 in the second direction DR2 of a portion of the first voltage line VL1-1 that overlaps the first pixel electrode AER and the second pixel electrode AEG may be greater than the maximum width WTM2 in the second direction DR2 of a portion of the second voltage line VL1-2 that overlaps the third pixel electrode AEB and the maximum width WTM3 in the second direction DR2 of a portion of the third voltage line VL1-3 that overlaps the third pixel electrode AEB.

In an embodiment of the present invention, the maximum width WTM1 in the second direction DR2 of a portion of the first voltage line VL1-1 that overlaps the first pixel electrode AER may be greater than the maximum width WTG in the second direction DR2 of a portion of the first voltage line VL1-1 that overlaps the second pixel electrode AEG.

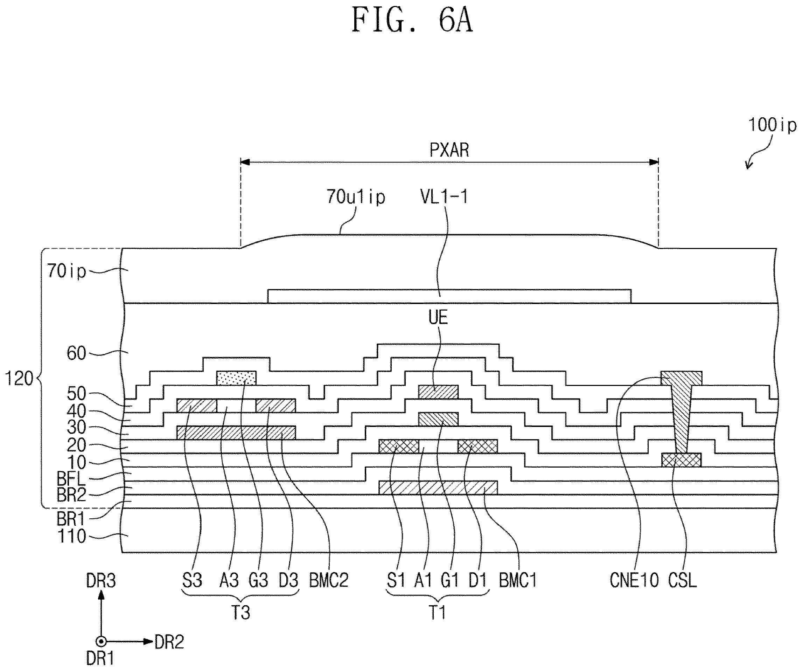

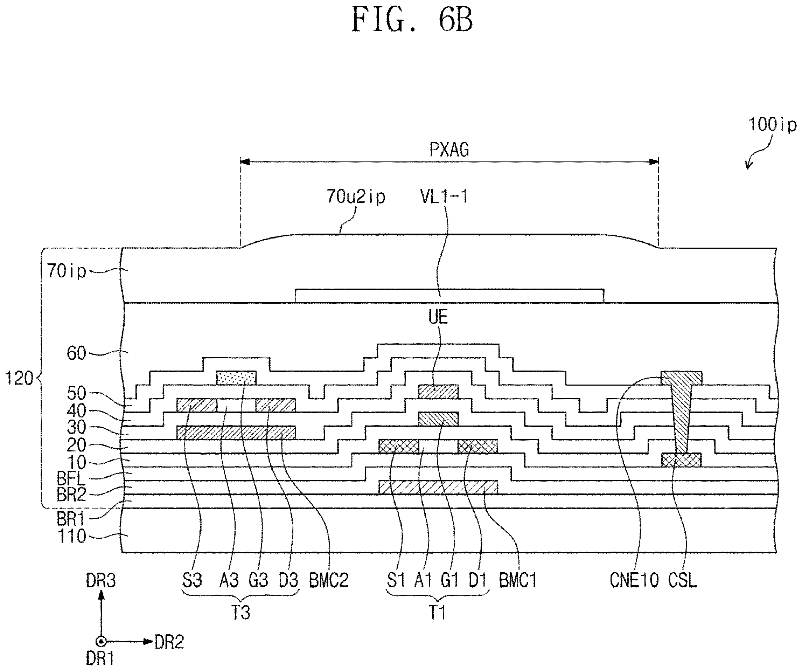

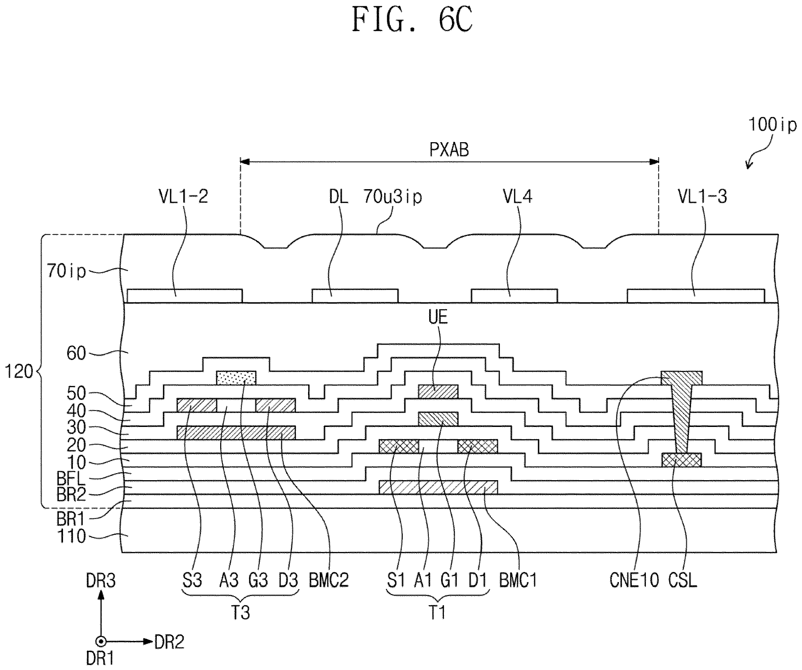

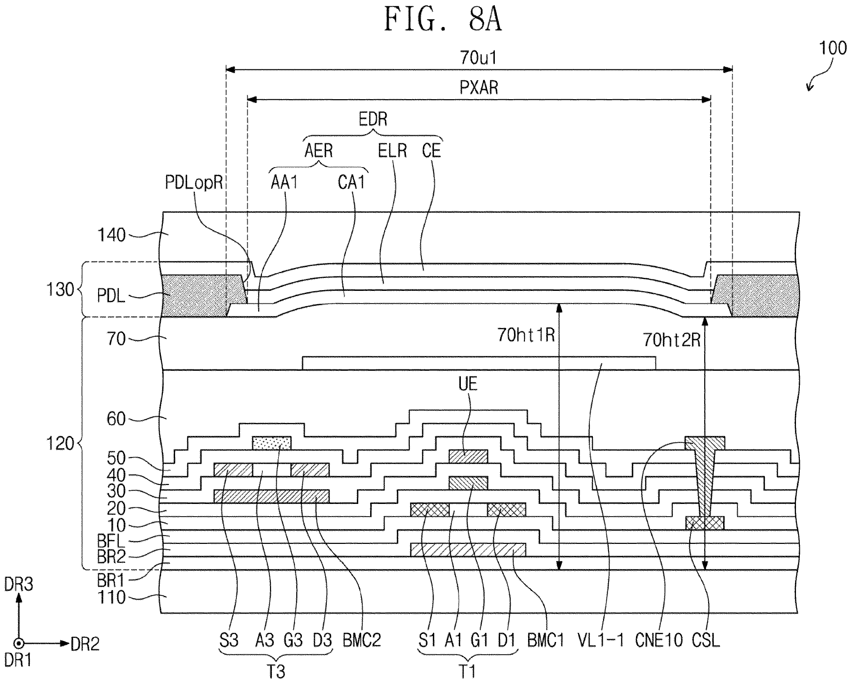

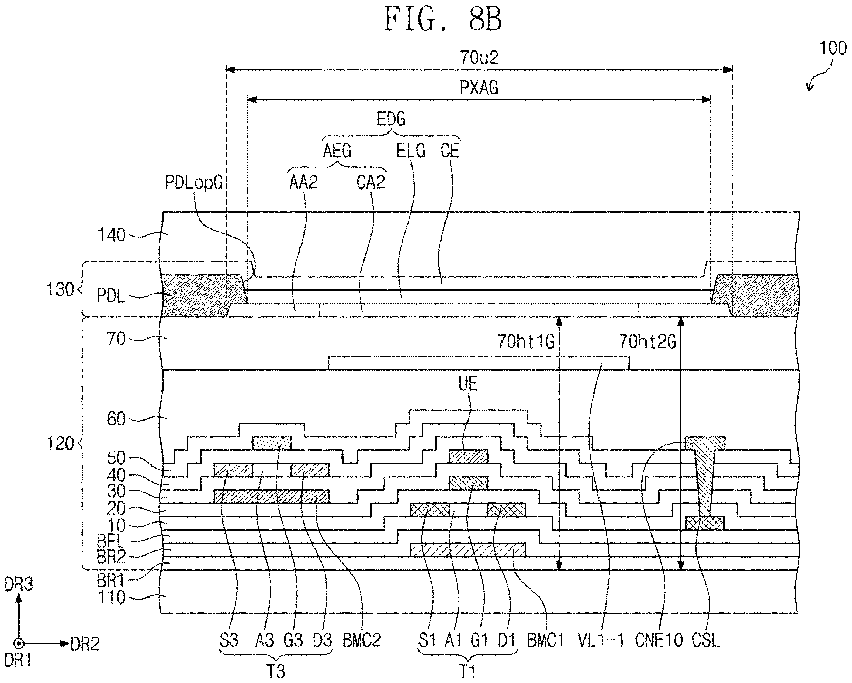

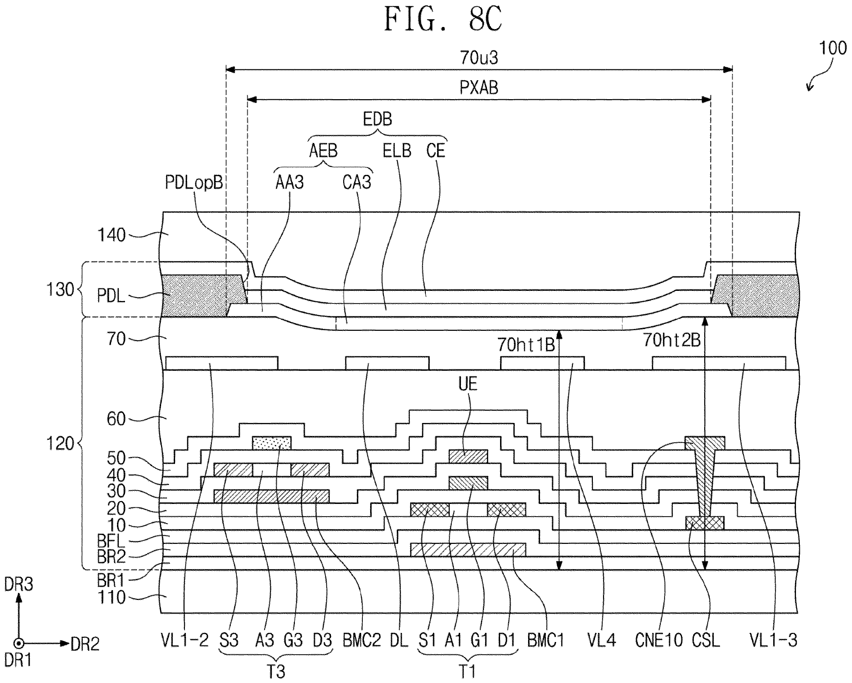

FIG. 6A is a cross-sectional view of a preliminary display layer 100ip, or in other words of an electronic device 1000, according to an embodiment of the present invention. FIG. 6B is a cross-sectional view of the preliminary display layer 100ip according to an embodiment of the present invention. FIG. 6C is a cross-sectional view of the preliminary display layer 100ip according to an embodiment of the present invention. For example, FIG. 6A is a cross-sectional view of a portion corresponding to a first emissive region PXAR, FIG. 6B is a cross-sectional view of a portion corresponding to a second emissive region PXAG, and FIG. 6C is a cross-sectional view of a portion corresponding to a third emissive region PXAB. The first to third emissive regions PXAR, PXAG, and PXAB may be regions defined by first to third openings PDLopR, PDLopG, and PDLopB (see, e.g., FIGS. 8A, 8B, and 8C), which will be described below.

Referring to FIGS. 6A, 6B, and 6C, the preliminary display layer 100ip, or in other words of the electronic device 1000, includes the base layer 110 and the circuit layer 120 disposed on the base layer 110.

At least one inorganic layer is formed on an upper surface of the base layer 110. The inorganic layer may include at least one of aluminum oxide, titanium oxide, silicon oxide, silicon oxy-nitride, zirconium oxide, and hafnium oxide. The inorganic layer may be formed of multiple layers. The multiple inorganic layers may constitute barrier layers BR1 and BR2 and/or a buffer layer BFL, which will be described below. The barrier layers BR1 and BR2 and the buffer layer BFL may be selectively disposed (or selectively formed).

The barrier layers BR1 and BR2 prevent infiltration of foreign matter from the outside. The barrier layers BR1 and BR2 may include a silicon oxide layer and a silicon nitride layer. A plurality of silicon oxide layers and a plurality of silicon nitride layers may be provided. The silicon oxide layers and the silicon nitride layers may be alternately stacked one above another.

The barrier layers BR1 and BR2 may include the first barrier layer BR1 and the second barrier layer BR2. A first back metal layer BMC1 may be disposed between the first barrier layer BR1 and the second barrier layer BR2. In an embodiment of the present invention, the first back metal layer BMC1 may be omitted.

The buffer layer BFL may be disposed on the barrier layers BR1 and BR2. The buffer layer BFL improves a coupling force (or adhesive force) between the base layer 110 and a semiconductor pattern and/or a conductive pattern. The buffer layer BFL may include silicon oxide layers and silicon nitride layers. The silicon oxide layers and the silicon nitride layers may be alternately stacked one above another.

A first semiconductor pattern may be disposed on the buffer layer BFL. The first semiconductor pattern may include a silicon semiconductor. For example, the silicon semiconductor may include amorphous silicon or polycrystalline silicon. For example, the first semiconductor pattern may include low-temperature polycrystalline silicon.

FIGS. 6A, 6B, and 6C illustrate only portions of the first semiconductor pattern disposed on the buffer layer BFL, and other portions of the first semiconductor pattern may be additionally disposed in other regions. The first semiconductor pattern may be arranged across the pixels in a pattern (e.g., according to a specific rule). The first semiconductor pattern may have different electrical properties depending on whether or not the first semiconductor pattern is doped or not. The first semiconductor pattern may have a first region having a high conductivity and a second region having a low conductivity. The first region may be doped with an N-type dopant or a P-type dopant. A P-type transistor may include a doped region that is doped with a P-type dopant, and an N-type transistor may include a doped region that is doped with an N-type dopant. The second region may be an un-doped region or may be a region more lightly doped when compared to the first region.

The conductivity of the first region may be higher than the conductivity of the second region, and the first region may act as an electrode or a signal line. The second region may substantially correspond to an active region (or a channel) of a transistor. In other words, one portion of the first semiconductor pattern may be an active region of the transistor, another portion may be a source or drain of the transistor, and yet another portion may be a connecting electrode or a connecting signal line.

The first electrode S1, an active region A1, and the second electrode D1 of the first transistor T1 are formed from the first semiconductor pattern. The first electrode S1 and the second electrode D1 of the first transistor T1 extend from the active region A1 in opposite directions.

In FIGS. 6A, 6B, and 6C, portions of a connecting signal line CSL formed from the first semiconductor pattern are illustrated. The connecting signal line CSL may be electrically connected to the second electrode of the fifth transistor T5 (see, e.g., FIG. 4) and the second emission control transistor ET2.

A first insulating layer 10 may be disposed on the buffer layer BFL. The first insulating layer 10 may commonly overlap the plurality of pixels and may cover the first semiconductor pattern. The first insulating layer 10 may be an inorganic layer and/or an organic layer and may have a single-layer structure or a multi-layer structure. The first insulating layer 10 may include at least one of aluminum oxide, titanium oxide, silicon oxide, silicon nitride, silicon oxy-nitride, zirconium oxide, and hafnium oxide. In the illustrated embodiment, the first insulating layer 10 is a single silicon oxide layer, but the present invention is not limited thereto. Not only the first insulating layer 10 but also insulating layers of the circuit layer 120, which will be described below, may be inorganic layers and/or organic layers and may have a single-layer structure or a multi-layer structure. The inorganic layers may include at least one of the aforementioned materials but are not limited thereto.

The third electrode G1 of the first transistor T1 is disposed on the first insulating layer 10. The third electrode G1 may be a portion of a metal pattern. The third electrode G1 of the first transistor T1 overlaps the active region A1 of the first transistor T1. The third electrode G1 of the first transistor T1 may act as a mask in a process of doping the first semiconductor pattern. The third electrode G1 may include titanium (Ti), silver (Ag), an alloy containing silver, molybdenum (Mo), an alloy containing molybdenum, aluminum (Al), an alloy containing aluminum, aluminum nitride (AIN), tungsten (W), tungsten nitride (WN), copper (Cu), indium tin oxide (ITO), or indium zinc oxide (IZO), but is not particularly limited thereto.

A second insulating layer 20 may be disposed on the first insulating layer 10 and may cover the third electrode G1 of the first transistor T1. The second insulating layer 20 may be an inorganic layer and/or an organic layer and may have a single-layer structure or a multi-layer structure. The second insulating layer 20 may include at least one of silicon oxide, silicon nitride, and silicon oxy-nitride. In one embodiment, the second insulating layer 20 may have a multi-layer structure including a silicon oxide layer and a silicon nitride layer.

An upper electrode UE and a second back metal layer BMC2 may be disposed on the second insulating layer 20. In an embodiment of the present invention, the second back metal layer BMC2 may be omitted. The upper electrode UE may overlap the third electrode G1. The upper electrode UE may be a portion of a metal pattern. A portion of the third electrode G1 and the upper electrode UE overlapping the portion of the third electrode G1 may define the capacitor Cst (see, e.g., FIG. 4). In an embodiment of the present invention, the second insulating layer 20 may be replaced with an insulating pattern. In such an embodiment, the upper electrode UE may be disposed on the insulating pattern. The upper electrode UE may act as a mask that forms the insulating pattern from the second insulating layer 20.

The second back metal layer BMC2 may be disposed under an oxide thin film transistor, for example, the third transistor T3, to correspond to the third transistor T3. A constant voltage or a signal may be applied to the second back metal layer BMC2. In an embodiment of the present invention, the second back metal layer BMC2 may be omitted.

A third insulating layer 30 may be disposed on the second insulating layer 20 and may cover the upper electrode UE and the second back metal layer BMC2. The third insulating layer 30 may have a single-layer structure or a multi-layer structure. For example, the third insulating layer 30 may have a multi-layer structure including a silicon oxide layer and a silicon nitride layer.

A second semiconductor pattern may be disposed on the third insulating layer 30. The second semiconductor pattern may include an oxide semiconductor. The oxide semiconductor may include a plurality of regions distinguished depending on whether or not the metal oxide is reduced or not. A region where the metal oxide is reduced (hereinafter referred to as the reduced region) has a higher conductivity than a region where metal oxide is not reduced (hereinafter referred to as the non-reduced region). The reduced region acts as a source/drain of a transistor or a signal line. The non-reduced region substantially corresponds to an active region (or a semiconductor region or a channel) of the transistor. In other words, one portion of the second semiconductor pattern may be an active region of the transistor, another portion may be a source/drain region of the transistor, and yet another portion may be a signal transmission region.

The first electrode S3, an active region A3, and the second electrode D3 of the third transistor T3 are formed from the second semiconductor pattern. The first electrode S3 and the second electrode D3 include metal reduced from a metal oxide semiconductor. The first electrode S3 and the second electrode D3 may extend from the active region A3 in opposite directions in the cross-section.

A fourth insulating layer 40 may be disposed on the third insulating layer 30. The fourth insulating layer 40 may commonly overlap the plurality of pixels and may cover the second semiconductor pattern. The fourth insulating layer 40 may include at least one of aluminum oxide, titanium oxide, silicon oxide, silicon nitride, silicon oxy-nitride, zirconium oxide, and hafnium oxide.

The third electrode G3 of the third transistor T3 is disposed on the fourth insulating layer 40. The third electrode G3 may be a portion of a metal pattern. The third electrode G3 of the third transistor T3 overlaps the active region A3 of the third transistor T3. The third electrode G3 may act as a mask in a process of reducing the second semiconductor pattern. In an embodiment of the present invention, the fourth insulating layer 40 may be replaced with an insulating pattern.

A fifth insulating layer 50 may be disposed on the fourth insulating layer 40 and may cover the third electrode G3. The fifth insulating layer 50 may be an inorganic layer.

A first connecting electrode CNE10 may be disposed on the fifth insulating layer 50. The first connecting electrode CNE10 may be connected to the connecting signal line CSL through a first contact hole (e.g., a first contact opening) penetrating (or extending through) the first to fifth insulating layers 10, 20, 30, 40, and 50.

A sixth insulating layer 60 may be disposed on the fifth insulating layer 50. The sixth insulating layer 60 may be an organic layer. The organic layer may include, but is not limited to, a general purpose polymer, such as benzocyclobutene (BCB), polyimide, hexamethyldisiloxane (HMDSO), polymethylmethacrylate (PMMA), or polystyrene (PS), a polymer derivative having a phenolic group, an acrylate-based polymer, an imide-based polymer, an aryl ether-based polymer, an amide-based polymer, a fluorine-based polymer, a p-xylene-based polymer, a vinyl alcohol-based polymer, or a blend thereof.

The first voltage line VL1-1, the second voltage line VL1-2, the third voltage line VL1-3, the data line DL, and the second initialization voltage line VL4 may be disposed on the sixth insulating layer 60. A second connecting electrode that makes contact with the first connecting electrode CNE10 and the light emitting element EDR (see, e.g., FIG. 8A) may also be disposed on the sixth insulating layer 60.

According to an embodiment of the present invention, the first voltage line VL1-1 may be expanded to overlap the first emissive region PXAR and the second emissive region PXAG. The second voltage line VL1-2 and the third voltage line VL1-3 may be disposed to overlap the third emissive region PXAB. The first, second and third pixel electrodes AER, AEG, and AEB may be located in the first, second, and third emissive regions PXAR, PXAG, PXAB. In such an embodiment, the resistance of the drive voltage line VL1 (see, e.g., FIG. 5) may be decreased, and thus, the power consumption of the electronic device 1000 (see, e.g., FIG. 1) may be reduced.

A seventh preliminary insulating layer 70ip, also called as insulating layer 70, may be disposed on the sixth insulating layer 60 and may cover the first voltage line VL1-1, the second voltage line VL1-2, the third voltage line VL1-3, the data line DL, and the second initialization voltage line VL4. The seventh preliminary insulating layer 70ip may be an organic layer. The seventh preliminary insulating layer 70ip, also called as insulating layer 70, cover the plurality of pixel drive circuits PDC.

The seventh preliminary insulating layer 70ip may have a first preliminary upper surface portion 70u1ip, a second preliminary upper surface portion 70u2ip, and a third preliminary upper surface portion 70u3ip that correspond to the first to third emissive regions PXAR, PXAG, and PXAB, respectively. The first preliminary upper surface portion 70u1ip, the second preliminary upper surface portion 70u2ip, and the third preliminary upper surface portion 70u3ip may also be called as upper surface portions 70u1, 70u2 and 70u3. Each of the first preliminary upper surface portion 70u1ip and the second preliminary upper surface portion 70u2ip may have a shape in which a central portion is convex (e.g., outwardly protrudes) due to the first voltage line VL1-1. The third preliminary upper surface portion 70u3ip may have an uneven shape due to the second voltage line VL1-2, the third voltage line VL1-3, the data line DL, and the second initialization voltage line VL4.

The uneven shape may be convex or concave, e. g. a concave or a convex shape.

The first preliminary upper surface portion 70u1ip, the second preliminary upper surface portion 70u2ip, and the third preliminary upper surface portion 70u3ip may also be called as upper surface portions 70u1, 70u2 and 70u3, may have a dome shape.

In an embodiment of the present invention, the degree of flatness of the seventh preliminary insulating layer 70ip may be controlled to improve viewing angle characteristics of the electronic device 1000 (see, e.g., FIG. 1). Accordingly, the degree of flatness of upper surface portions of a seventh insulating layer 70 (see, e.g., FIGS. 8A, 8B, and 8C), also called as insulating layer, that overlap the plurality of light emitting elements EDR, EDG, and EDB (see, e.g., FIG. 3) may differ from one another.

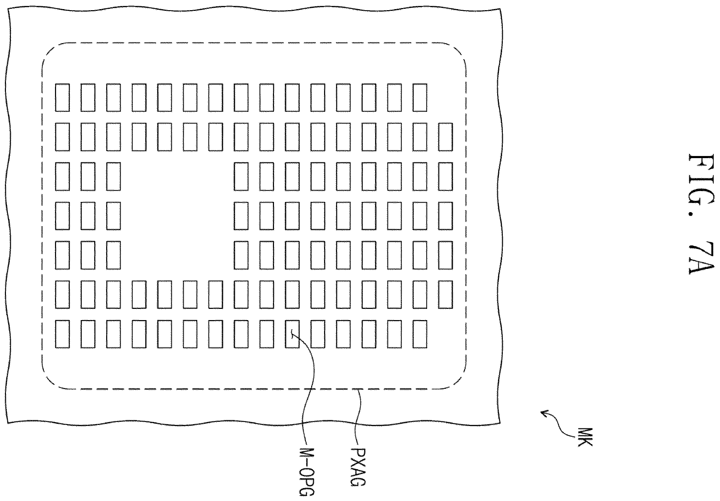

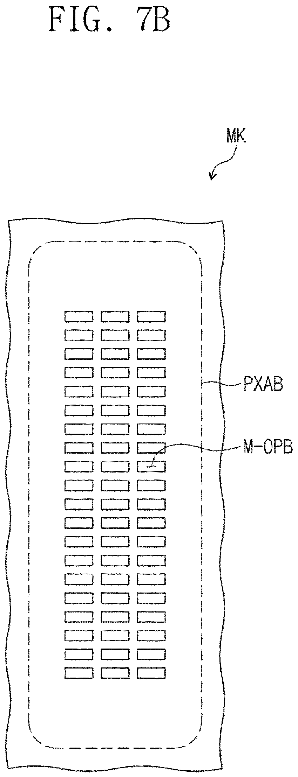

FIG. 7A is a plan view of a mask MK used in a manufacturing process of the display layer according to an embodiment of the present invention. FIG. 7B is a plan view of the mask MK used in the manufacturing process of the display layer according to an embodiment of the present invention.

Referring to FIGS. 6B and 7A, a portion illustrated in FIG. 7A is a portion of the mask MK used to control the degree of flatness of the second preliminary upper surface portion 70u2ip of the seventh preliminary insulating layer 70ip. Referring to FIGS. 6C and 7B, a portion illustrated in FIG. 7B is a portion of the mask MK used to control the degree of flatness of the third preliminary upper surface portion 70u3ip of the seventh preliminary insulating layer 70ip.

Referring to FIGS. 6A, 6B, 6C, 7A, and 7B, the mask MK may be a mask used in a process of forming a VIA hole 70cnt (see, e.g., FIG. 5) in the seventh preliminary insulating layer 70ip. In such an embodiment, the degree of flatness of the seventh preliminary insulating layer 70ip may be controlled while the VIA hole 70cnt is being formed in the seventh preliminary insulating layer 70ip. However, the present invention is not limited thereto. For example, the mask MK may be a mask used before or after the process of forming the VIA hole 70cnt. In such an embodiment, the process of forming the VIA hole 70cnt in the seventh preliminary insulating layer 70ip and the process of controlling the degree of flatness of the seventh preliminary insulating layer 70ip may be separately performed.

In an embodiment of the present invention, a flatness control process may be performed on the second preliminary upper surface portion 70u2ip and the third preliminary upper surface portion 70u3ip. However, this is illustrative, and the present invention is not limited thereto. For example, a flatness control process may be performed on at least one of the first preliminary upper surface portion 70u1ip, the second preliminary upper surface portion 70u2ip, and the third preliminary upper surface portion 70u3ip to adjust viewing angle characteristics.

A plurality of first slits M-OPG may be provided in a region corresponding to the second emissive region PXAG of the mask MK, and a plurality of second slits M-OPB may be provided in a region corresponding to the third emissive region PXAB of the mask MK. The mask MK may be a mask used in a process of exposing the seventh preliminary insulating layer 70ip. Accordingly, the heights of portions of the seventh preliminary insulating layer 70ip that overlap the first slits M-OPG and the second slits M-OPB may be decreased.

For example, as the first slits M-OPG are arranged to correspond to a convex portion of the second preliminary upper surface portion 70u2ip, the shape of the second preliminary upper surface portion 70u2ip may be changed or deformed. For example, the degree of flatness of the second preliminary upper surface portion 70u2ip may be improved. As the second slits M-OPB are arranged to correspond to the center of the third preliminary upper surface portion 70u3ip, the shape of the third preliminary upper surface portion 70u3ip may be changed or deformed. For example, the third preliminary upper surface portion 70u3ip may be deformed to have a concave shape, and the degree of flatness of the third preliminary upper surface portion 70u3ip may be reduced.

The degree of flatness of the seventh preliminary insulating layer 70ip may be changed depending on the positions of components included in the circuit layer 120. This may cause a change in color coordinates, and therefore, viewing angle characteristics may be changed. According to an embodiment of the present invention, a process of controlling the degree of flatness of the seventh preliminary insulating layer 70ip may be added (or may be additionally performed). That is, viewing angle characteristics may be improved by controlling the shape of the upper surface of the seventh preliminary insulating layer 70ip. Thus, the display quality of the electronic device 1000 (see, e.g., FIG. 1) may be improved.

FIG. 8A is a cross-sectional view of the display layer 100 according to an embodiment of the present invention. FIG. 8B is a cross-sectional view of the display layer 100 according to an embodiment of the present invention. FIG. 8C is a cross-sectional view of the display layer 100 according to an embodiment of the present invention. FIG. 8A is a cross-sectional view of a portion corresponding to the first emissive region PXAR, FIG. 8B is a cross-sectional view of a portion corresponding to the second emissive region PXAG, and FIG. 8C is a cross-sectional view of a portion corresponding to the third emissive region PXAB.

Referring to FIGS. 8A, 8B, and 8C, the seventh insulating layer 70, also called as insulating layer, may be disposed on the sixth insulating layer 60 and may cover the first voltage line VL1-1, the second voltage line VL1-2, the third voltage line VL1-3, the data line DL, and the second initialization voltage line VL4. The seventh insulating layer 70 may be an organic layer. The seventh insulating layer 70 may be referred to as the insulating layer.

The seventh insulating layer 70 may have a first upper surface portion 70u1, a second upper surface portion 70u2, and a third upper surface portion 70u3 that correspond to the first to third emissive regions PXAR, PXAG, and PXAB, respectively. The first to third upper surface portions 70u1, 70u2, and 70u3 may be portions that overlap the first to third pixel electrodes AER, AEG, and AEB, to be described below.

In an embodiment of the present invention, the degrees of flatness of the first to third upper surface portions 70u1, 70u2, and 70u3 may differ from one another. For example, the degree of flatness of the second upper surface portion 70u2 may be higher than the degree of flatness of the first upper surface portion 70u1 and the degree of flatness of the third upper surface portion 70u3. When the degree of flatness of the second upper surface portion 70u2 is higher than the degree of flatness of the first upper surface portion 70u1 and the degree of flatness of the third upper surface portion 70u3, this may mean that the second upper surface portion 70u2 has a flatter shape (or profile) than the first upper surface portion 70u1 and the third upper surface portion 70u3. In an embodiment of the present invention, the first upper surface portion 70u1 may have a convex shape, and the third upper surface portion 70u3 may have a concave shape. In an embodiment of the present invention, the first upper surface portion 70u1 may have a concave shape, and the third upper surface portion 70u3 may have a convex shape. In other words, the upper surface portions 70u1, 70u2 and 70u3 may each have a dome shape.

The light emitting element layer 130 may be disposed on the circuit layer 120. The light emitting element layer 130 may include the plurality of light emitting elements EDR, EDG, and EDB.

The first emissive region PXAR may be defined to correspond to the first light emitting element EDR, the second emissive region PXAG may be defined to correspond to the second light emitting element EDG, and the third emissive region PXAB may be defined to correspond to the third light emitting element EDB.

The first light emitting element EDR may include the first pixel electrode AER, a first emissive layer ELR, and a common electrode CE. The second light emitting element EDG may include the second pixel electrode AEG, a second emissive layer ELG, and the common electrode CE. The third light emitting element EDB may include the third pixel electrode AEB, a third emissive layer ELB, and the common electrode CE.

In an embodiment of the present invention, the first to third light emitting elements EDR, EDG, and EDB may further include a first functional layer disposed between the first to third pixel electrodes AER, AEG, and AEB and the first to third emissive layers ELR, ELG, and ELB and a second functional layer disposed between the first to third emissive layers ELR, ELG, and ELB and the common electrode CE. The first functional layer, the second functional layer, and the common electrode CE may be commonly provided for the plurality of pixels.

Referring to FIGS. 8A, 8B, and 8C, the first to third pixel electrodes AER, AEG, and AEB may be disposed on the seventh insulating layer 70 in direct contact with the seventh insulating layer 70, also called as insulating layer 70ip. The first pixel electrode AER may overlap the first upper surface portion 70u1, the second pixel electrode AEG may overlap the second upper surface portion 70u2, and the third pixel electrode AEB may overlap the third upper surface portion 70u3.

In an embodiment of the present invention, the first upper surface portion 70u1 may have a convex shape. For example, the first height 70ht1R of a portion of the first upper surface portion 70u1 overlapping the first central region CA1 of the first pixel electrode AER may be greater than the second height 70ht2R of a portion of the first upper surface portion 70u1 overlapping the first outer region AA1 of the first pixel electrode AER. The heights may correspond to the distances from the upper surface of the base layer 110 to the first upper surface portion 70u1.

In an embodiment of the present invention, the second upper surface portion 70u2 may have a flat shape. For example, the first height 70ht1G of a portion of the second upper surface portion 70u2 overlapping the second central region CA2 of the second pixel electrode AEG may be substantially the same as the second height 70ht2G of a portion of the second upper surface portion 70u2 overlapping the second outer region AA2 of the second pixel electrode AEG. When the first height 70ht1G is substantially the same as the second height 70ht2G, this may mean that the first height 70ht1G is not exactly (or completely) the same as the second height 70ht2G. For example, when the first height 70ht1G is substantially the same as the second height 70ht2G, there may be a level of difference (e.g., a predetermined difference) between the first height 70ht1G and the second height 70ht2G. The level of difference may be regarded as substantially the same level when the difference between the first height 70ht1G and the second height 70ht2G is 2,000 angstroms or less but is not limited thereto.

In an embodiment of the present invention, the third upper surface portion 70u3 may have a concave shape. For example, the first height 70ht1B of a portion of the third upper surface portion 70u3 overlapping the third central region CA3 of the third pixel electrode AEB may be smaller than the second height 70ht2B of a portion of the third upper surface portion 70u3 overlapping the third outer region AA3 of the third pixel electrode AEB.

At least some of the first to third pixel electrodes AER, AEG, and AEB may have a bent shape to correspond to the shapes of the first to third upper surface portions 70u1, 70u2, and 70u3. Accordingly, the degrees of flatness of the first to third pixel electrodes AER, AEG, and AEB may differ from one another. For example, on the section, the first pixel electrode AER may have a convex shape, the second pixel electrode AEG may have a flat shape, and the third pixel electrode AEB may have a concave shape.

A pixel defining layer PDL may be disposed on the seventh insulating layer 70 and may cover a portion of the first pixel electrode AER, a portion of the second pixel electrode AEG, and a portion of the third pixel electrode AEB. The first opening PDLopR, the second opening PDLopG, and the third opening PDLopB may be defined in the pixel defining layer PDL. The first emissive region PXAR may be defined by the first opening PDLopR, the second emissive region PXAG may be defined by the second opening PDLopG, and the third emissive region PXAB may be defined by the third opening PDLopB. The first to third openings PDLopR, PDLopG, and PDLopB may expose at least portions of the first to third pixel electrodes AER, AEG, and AEB, respectively.

In an embodiment of the present invention, the pixel defining layer PDL may further include a black material. The pixel defining layer PDL may include a black organic dye/pigment, such as carbon black, aniline black, or the like. The pixel defining layer PDL may be formed by mixing a blue organic material and a black organic material. The pixel defining layer PDL may include a liquid-repellent organic material.

The first emissive layer ELR of the first light emitting element EDR may be disposed in a region corresponding to the first opening PDLopR, the second emissive layer ELG of the second light emitting element EDG may be disposed in a region corresponding to the second opening PDLopG, and the third emissive layer ELB of the third light emitting element EDB may be disposed in a region corresponding to the third opening PDLopB.

The first to third emissive layers ELR, ELG, and ELB may generate light having certain (e.g., different or predetermined) colors. For example, the first emissive layer ELR may emit red light, the second emissive layer ELG may emit green light, and the third emissive layer ELB may emit blue light. However, the present invention is not limited thereto. For example, the first to third emissive layers ELR, ELG, and ELB may all emit blue light or white light. Although the present embodiment has been described in connection with patterned first to third emissive layers ELR, ELG, and ELB, in another embodiment, one emissive layer may be commonly disposed in the plurality of emissive regions. In such an embodiment, the emissive layer may generate white light or blue light. Furthermore, the emissive layer may have a multi-layer structure called tandem.

Each of the first to third emissive layers ELR, ELG, and ELB may include a low molecular weight organic material or a high molecular weight organic material as a luminescent material. In another embodiment, the first emissive layer ELR may include a quantum dot material as a luminescent material. A core of a quantum dot may be selected from Group II-VI compounds, Group III-V compounds, Group IV-VI compounds, Group IV elements, Group IV compounds, and combinations thereof.

The light emitting element layer 130 may further include a capping layer disposed on the common electrode CE. The capping layer may improve light emission efficiency due to constructive interference. The capping layer may include, for example, a material having a refractive index of about 1.6 or more for light having a wavelength of about 589 nm. The capping layer may be an organic capping layer including an organic material, an inorganic capping layer including an inorganic material, or a composite capping layer including an organic material and an inorganic material. For example, the capping layer may include a carbocyclic compound, a heterocyclic compound, an amine group-containing compound, a porphine derivative, a phthalocyanine derivative, a naphthalocyanine derivative, an alkali metal complex, an alkaline earth metal complex, or a combination thereof. A substituent including O, N, S, Se, Si, F, Cl, Br, I, or a combination thereof may be selectively substituted for the carbocyclic compound, the heterocyclic compound, and the amine group-containing compound.

The encapsulation layer 140 may be disposed on the light emitting element layer 130. The encapsulation layer 140 includes at least an inorganic layer or an organic layer. In an embodiment of the present invention, the encapsulation layer 140 may include two inorganic layers with an organic layer disposed therebetween. In an embodiment of the present invention, the encapsulation layer 140 may include a plurality of inorganic layers and a plurality of organic layers that are alternately stacked one above another.

The inorganic encapsulation layers protect the first to third light emitting elements EDR, EDG, and EDB from moisture/oxygen, and the organic encapsulation layers protect the first to third light emitting elements EDR, EDG, and EDB from foreign matter, such as dust particles. The inorganic encapsulation layers may include a silicon nitride layer, a silicon oxy-nitride layer, a silicon oxide layer, a titanium oxide layer, or an aluminum oxide layer but are not limited thereto. The organic encapsulation layers may include an acrylate-based organic layer but are not limited thereto.

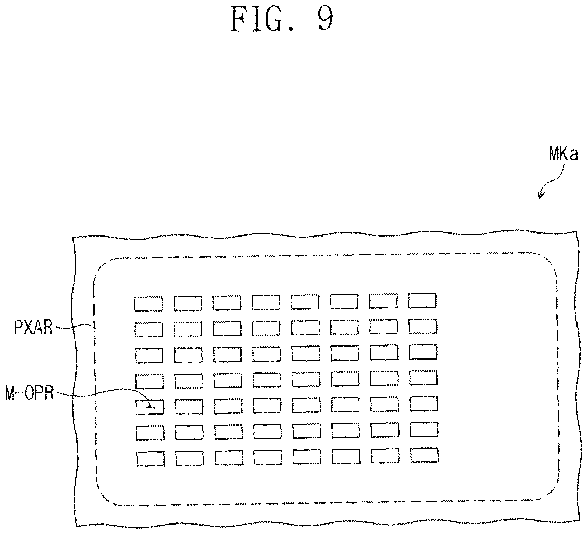

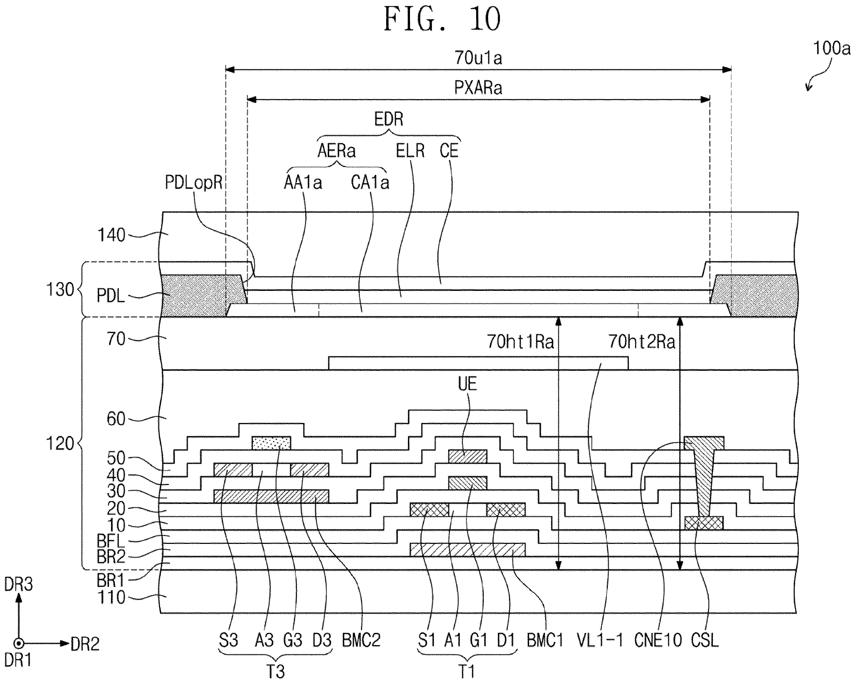

FIG. 9 is a plan view of a mask MKa used in a manufacturing process of a display layer according to an embodiment of the present invention. FIG. 10 is a cross-sectional view of the display layer 100a according to an embodiment of the present invention.

Referring to FIGS. 6A, 9, and 10, a portion illustrated in FIG. 9 is a portion of the mask MKa used to control the degree of flatness of a first preliminary upper surface portion 70u1ip of a seventh preliminary insulating layer 70ip.

In an embodiment of the present invention, a flatness control process may also be performed on the first preliminary upper surface portion 70u1ip. For example, in an embodiment of the present invention, a flatness control process may be performed on the first preliminary upper surface portion 70u1ip, the second preliminary upper surface portion 70u2ip (see, e.g., FIG. 6B), and the third preliminary upper surface portion 70u3ip (see, e.g., FIG. 6C) to adjust viewing angle characteristics. The flatness control process of the second preliminary upper surface portion 70u2ip (see, e.g., FIG. 6B) and the third preliminary upper surface portion 70u3ip (see, e.g., FIG. 6C) have been described with reference to FIGS. 6B, 6C, 7A, 7B, 8A, and 8B, and therefore, descriptions thereof will be omitted.

A plurality of third slits M-OPR may be provided in a region corresponding to a first emissive region PXAR of the mask MKa. The mask MKa may be a mask used in a process of exposing the seventh preliminary insulating layer 70ip. Accordingly, the height of a portion of the seventh preliminary insulating layer 70ip that overlaps the third slits M-OPR may be reduced. For example, as the third slits M-OPR are arranged to correspond to a convex portion of the first preliminary upper surface portion 70u1ip, the shape of the first preliminary upper surface portion 70u1ip may be deformed. For example, the degree of flatness of the first preliminary upper surface portion 70u1ip may be improved.

A seventh insulating layer 70 may include a first upper surface portion 70u1a corresponding to a first emissive region PXARa. In an embodiment of the present invention, the first upper surface portion 70u1a may have a flat shape. For example, the first height 70ht1Ra of a portion of the first upper surface portion 70u1a overlapping a first central region CA1a of a first pixel electrode AERa may be substantially the same as the second height 70ht2Ra of a portion of the first upper surface portion 70u1a overlapping a first outer region AA1a of the first pixel electrode AERa. When the first height 70ht1Ra is substantially the same as the second height 70ht2Ra, this may mean that the first height 70ht1Ra is not exactly the same as the second height 70ht2Ra. For example, when the first height 70ht1Ra is substantially the same as the second height 70ht2Ra, there may be a level of difference (e.g., a predetermined difference) between the first height 70ht1Ra and the second height 70ht2Ra.

The degree of flatness of the seventh preliminary insulating layer 70ip may be changed depending on the positions of components included in a circuit layer 120. This may cause a change in color coordinates, and therefore, viewing angle characteristics may be changed. According to an embodiment of the present invention, a process of controlling the degree of flatness of the seventh preliminary insulating layer 70ip may be performed. That is, viewing angle characteristics may be improved by controlling the shape of the upper surface of the seventh preliminary insulating layer 70ip. Thus, the display quality of the electronic device 1000 (see, e.g., FIG. 1) may be improved.

As described above, optical characteristics of the display layer may be adjusted by the intentionally formed steps or flat surfaces of the insulating layer. Accordingly, viewing angle characteristics of the display layer may be improved, and thus, the electronic device may have improved display quality.

## Claims

1. An electronic device (1000) comprising:
a base layer (110);
a circuit layer (120) on the base layer (110), the circuit layer (120) comprising a plurality of pixel drive circuits (PDC) and an insulating layer (70, 70ip) covering the plurality of pixel drive circuits (PDC); and
a light emitting element layer (130) on the circuit layer (120), the light emitting element layer (130) comprising a plurality of light emitting elements (ED) respectively electrically connected to the plurality of pixel drive circuits (PDC),
wherein the plurality of light emitting elements (ED) comprises a first light emitting element (EDR) comprising a first pixel electrode (AER), a second light emitting element (EDG) comprising a second pixel electrode (AEG), and a third light emitting element (EDB) comprising a third pixel electrode (AEB),
wherein the insulating layer (70, 70ip) has a first upper surface portion (70u1) overlapping the first pixel electrode (AER), a second upper surface portion (70u2) overlapping the second pixel electrode (AEG), and a third upper surface portion (70u3) overlapping the third pixel electrode (AEB), and
wherein degrees of flatness of the first upper surface portion (70u1), the second upper surface portion (70u2), and the third upper surface portion (70u3) differ from one another.

2. The electronic device (1000) of claim 1, wherein the circuit layer (120) further comprises a drive voltage (ELVDD) line (VL1) configured to provide a drive voltage (ELVDD) to the plurality of pixel drive circuits (PDC), and
wherein the drive voltage line (VL1) overlaps at least portions of the first pixel electrode (AER), the second pixel electrode (AEG), and the third pixel electrode (AEB).

3. The electronic device (1000) of claim 1 or 2, wherein the first pixel electrode (AER) has a first central region (CA1) and a first outer region (AA1) adjacent to the first central region (CA1),
wherein the second pixel electrode (AEG) has a second central region (CA2) and a second outer region (AA2) adjacent to the second central region (CA2),
wherein the third pixel electrode (AEB) has a third central region (CA3) and a third outer region (AA3) adjacent to the third central region (CA3), and
wherein the drive voltage line (VL1) overlaps at least one of the first central region (CA1) and the second central region (CA2).

4. The electronic device (1000) of claim 3, wherein the drive voltage line (VL1) does not overlap the third central region (CA3) and overlaps the third outer region (AA3).

5. The electronic device (1000) of claim 3 or 4, wherein a height of a portion of the first upper surface portion (70u1) overlapping the first central region (CA1) is greater than a height of a portion of the first upper surface portion (70u1) overlapping the first outer region (AA1).

6. The electronic device (1000) of at least one of claims 3 to 5, wherein a height of a portion of the third upper surface portion (70u3) overlapping the third central region (CA3) is smaller than a height of a portion of the third upper surface portion (70u3) overlapping the third outer region (AA3).

7. The electronic device (1000) of at least one of claims 1 to 6, wherein the degree of flatness of the second upper surface portion (70u2) is higher than the degree of flatness of the first upper surface portion (70u1) and the degree of flatness of the third upper surface portion (70u3).

8. The electronic device (1000) of at least one of claims 1 to 7, wherein the first light emitting element (EDR) is a red light emitting element, the second light emitting element (EDG) is a green light emitting element, and the third light emitting element (EDB) is a blue light emitting element.

9. The electronic device (1000) of at least one of claims 1 to 8, wherein the first light emitting element (EDR) and the second light emitting element (EDG) are alternately and repeatedly arranged in a first direction (DR1), and the third light emitting element (EDB) is adjacent to the first light emitting element (EDR) and the second light emitting element (EDG) in a second direction (DR2) crossing the first direction (DR1).

10. The electronic device (1000) of at least one of claims 1 to 9, wherein the circuit layer (120) further comprises a drive voltage (ELVDD) line (VL1) configured to provide a drive voltage (ELVDD) to the plurality of pixel drive circuits (PDC), and
wherein the drive voltage (ELVDD) line (VL1) comprises:
a first voltage line (VL1-1) extending in a first direction (DR1) and overlapping the first pixel electrode (AER) and the second pixel electrode (AEG); and
a second voltage line (VL1-2) and a third voltage line (VL1-3) configured to overlap the third pixel electrode (AEB).

11. The electronic device (1000) of claim 10, wherein the first voltage line (VL1-1), the second voltage line (VL1-2), and the third voltage line (VL1-3) are spaced apart from each other in a second direction (DR2) crossing the first direction (DR1), and
wherein a maximum width of a portion of the first voltage line (VL1-1) overlapping the first pixel electrode (AER) and the second pixel electrode (AEG) in the second direction (DR2) is greater than a maximum width of a portion of the second voltage line (VL1-2) overlapping the third pixel electrode (AEB) in the second direction (DR2) and a maximum width of a portion of the third voltage line (VL1-3) overlapping the third pixel electrode (AEB) in the second direction (DR2).

12. The electronic device (1000) of at least one of claims 1 to 11, wherein the insulating layer (70, 70ip) is an organic layer, and
wherein the first pixel electrode (AER), the second pixel electrode (AEG), and the third pixel electrode (AEB) are directly on an upper surface of the insulating layer (70, 70ip).
